# EUROPÄISCHE PATENTSCHRIFT

(11) **EP 0 899 356 B1**
(45) Veröffentlichungstag und Bekanntmachung des Hinweises auf die Patenterteilung: **10.01.2001**
(21) Anmeldenummer: 98110242.9
(22) Anmeldetag: 05.06.1998
(51) Int. Cl.: C23C 14/04

(54) **Verfahren und Vorrichtung zur Innenbeschichtung eines Metallrohres**
Method and apparatus for coating the inside of a metal tube
Méthode et dispositif pour la formation d'un revêtenment sur la paroi interne d'un tube métallique

(30) Priorität: 20.08.1997 DE 19736028
(43) Veröffentlichungstag der Anmeldung: 03.03.1999
(73) Patentinhaber: Rheinmetall W & M GmbH, 29345 Unterlüss (DE); TZN-Forschungs- und Entwicklungszentrum Unterlüss GmbH, 39345 Unterlüss (DE)
(72) Erfinder: Weise, Thomas, Dr., 29345 Unterlüss (DE); Neff, Helmut, Dr., 29320 Hermannsburg (DE); Voronov, Alexei, Dr., 29345 Unterlüss (DE); Schlenkert, Gert, 40233 Düsseldorf (DE)
(74) Vertreter: Behrend, Rainer

(56) Entgegenhaltungen:
- DE-A- 3 435 320
- GB-A- 1 482 219
- GB-A- 2 158 103
- US-A- 4 354 456

## Beschreibung

Die Erfindung betrifft ein Verfahren zum Innenbeschichten eines Metallrohres **oder eines Rohrabschnittes des Metallrohres, insbesondere eines Waffenrohres, mit einem elektrisch leitfähigen Schichtwerkstoff.** Die Erfindung bezieht sich ferner auf eine Vorrichtung zur Durchführung des Verfahrens.

In der Waffentechnik bewirken leistungsgesteigerte Munitionsarten aufgrund ihrer beim Abschuß entstehenden hohen Gastemperaturen und Strömungsgeschwindigkeiten insbesondere bei den aus Stahl bestehenden Waffenrohren starke Erosionen, die das jeweilige Waffenrohr bereits vor Erreichen seiner Ermüdungslebensdauer verschleißen. Es ist bereits bekannt, die entsprechenden Waffenrohre zwecks Vermeidung derartiger Erosionen mit einer Hartchromschicht zu versehen. Dabei wird der Hartchrom elektrolytisch an der inneren Oberfläche des Waffenrohres abgeschieden.

Nachteilig ist bei diesem bekannten Verfahren unter anderem, daß die elektrolytisch abgeschiedenen Hartchromschichten sehr spröde sind und den Belastungen der leistungsgesteigerten Munition nicht standhalten. An den sich dadurch ergebenden Chrombrüchen entstehen nach und nach starke Erosionen.

**Aus der GB-A-1 482 219 ist ein Verfahren zum Aufbringen dünner Schichten auf die innere Oberfläche eines Metallrohres bekannt. Dabei wird durch einen aus Schichtmaterial bestehenden, sich parallel zur Rohrachse erstreckenden dünnen Draht ein elektrischer Stromimpuls hindurchgeleitet, dessen Stromstärke derart gewählt ist, daß der Draht schlagartig verdampft. Die verdampften Partikel des Schichtwerkstoffes prallen dann auf die innere Oberfläche des Rohres auf und bilden dort eine entsprechende Schutzschicht**.

**Aus der GB-A-2 158 103 sind ferner Waffenrohre bekannt, deren innere Oberfläche mit Hartmetallen beschichtet werden. Zur Durchführung der Beschichtung wird in dieser Druckschrift unter anderem auf bekannte Vakuum-Beschichtungsverfahren hingewiesen, bei denen hochenergetische Ionen des entsprechenden Beschichtungsmaterials erzeugt und auf die innere Oberfläche des jeweiligen Waffenrohres gelenkt werden.**

**Aus der US-A-4,354,456 ist schließlich eine Vorrichtung zur bereichsweisen Beschichtung der inneren Oberfläche von rohrförmigen Gegenständen bekannt, bei der ein mit Schichtmaterial versehener elektrischer Draht zwischen zwei den jeweils zu beschichtenden Bereich begrenzenden und sich über den Rohrquerschnitt erstreckenden Masken angeordnet ist. Wird durch den elektrischen Draht ein entsprechend hoher Strom geschickt, so verdampft das Schichtmaterial und schlägt sich auf der inneren Oberfläche des rohrförmigen Gegenstandes nieder.**

Der vorliegenden Erfindung liegt die Aufgabe zugrunde, ein Verfahren zur Innenbeschichtung eines Metallrohres anzugeben, mit dem auf einfache Weise insbesondere hochschmelzende Metalle auf die innere Oberfläche eines Metallrohres aufgebracht werden können, wobei die entsprechende auf dem Metallrohr aufgebrachte Schicht eine hohe Haftfestigkeit besitzen soll. Ferner soll eine Vorrichtung zur Durchführung des Verfahrens angegeben werden.

Diese Aufgabe wird hinsichtlich des Verfahrens durch die Merkmale des Anspruchs 1 und hinsichtlich der Vorrichtung durch die Merkmale des Anspruchs 5 gelöst. Weitere vorteilhafte Ausgestaltungen der Erfindung offenbaren die Unteransprüche.

Zur Durchführung des Verfahrens wird der Schichtwerkstoff zunächst in dem zu beschichtenden Rohr bzw. Rohrabschnitt in Richtung der Rohrachse in Form eines Drahtes angeordnet und dann durch den Draht ein elektrischer Stromimpuls geleitet, dessen Stromstärke derart gewählt wird, daß der Draht schlagartig verdampft. Die durch den verdampften Werkstoff entstehenden Partikel treffen mit hoher kinetischer Energie auf die innere Oberfläche des Rohres auf, wobei es an der Rohrwand zu lokalen Anschmelzungen dieser Partikel und zu einer Legierungsbildung zwischen dem zu beschichtenden Rohrwerkstoff und dem Schichtungswerkstoff kommt. Dadurch ergibt sich eine hohe Haftfestigkeit zwischen dem Rohr und dem Schichtwerkstoff.

Das erfindungsgemäße Verfahren weist außerdem den Vorteil auf, daß es für eine Vielzahl unterschiedlicher Schichtwerkstoffe anwendbar ist. Außerdem weist die nach dem erfindungsgemäßen Verfahren aufgebrachte Schicht eine gegenüber bekannten Verfahren mit thermisch gespritzten Schichten geringere Porosität auf.

Damit die Teilchengeschwindigkeit der beim Verdampfen des Schichtwerkstoffes entstehenden Partikel nicht durch die Luftmoleküle abgebremst wird, hat es sich ferner als vorteilhaft erwiesen, die Beschichtung in einem evakuierten Rohrinnenraum durchzuführen. Ein derartiges Verfahren weist außerdem die Vorteile auf, daß sowohl Clusterbildungen als auch Oxidationen der inneren Rohroberfläche vermieden werden.

Bei einem weiteren Ausführungsbeispiel hat es sich als zweckmäßig erwiesen, den Rohrinnenraum nicht zu evakuieren, sondern mit einem Arbeitsgas zu fluten. Dadurch ist es möglich, die Härte der Beschichtung weiter zu erhöhen. Als besonders vorteilhaft hat sich als Arbeitsgas Methan in Verbindung mit karbidbildenden Schichtwerkstoffen erwiesen.

Weitere Einzelheiten und Vorteile der Erfindung ergeben sich aus den folgenden anhand von Figuren erläuterten Ausführungsbeispielen. Es zeigen:
- Fig.1: schematisch den Längsschnitt eines zu beschichtenden Waffenrohres in Verbindung mit einer erfindungsgemäßen Vorrichtung vor Einleitung einer Drahtexplosion;
- Fig.2: die in Fig.1 dargestellte Anordnung beim Verdampfen des aus Schichtwerkstoff bestehenden Drahtes und
- Fig.3: das in Fig.1 und 2 dargestellte Waffenrohr nach Durchführung der Beschichtung.

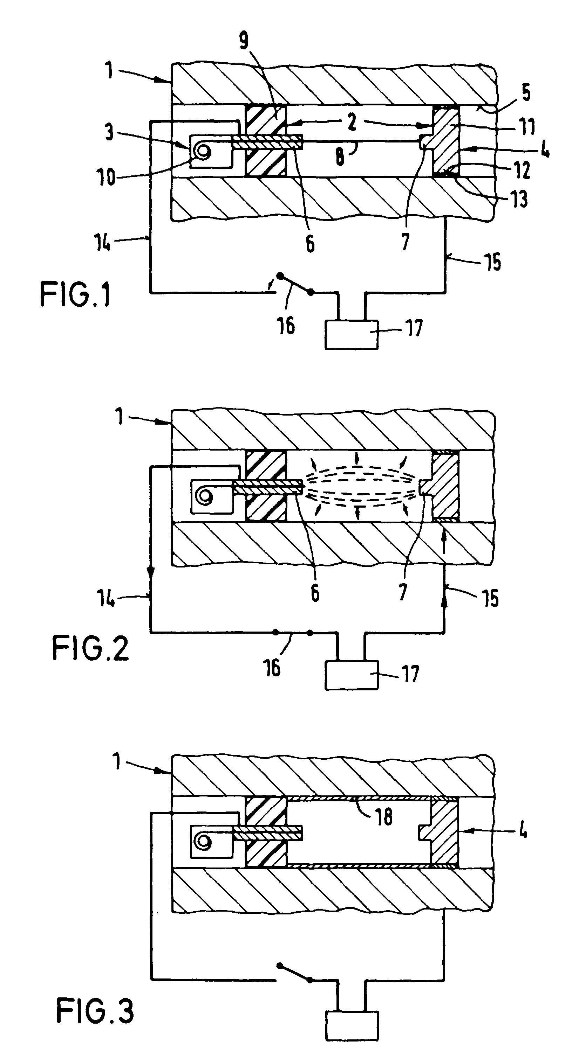

In den Fig.1-3 ist mit 1 ein zu beschichtendes Waffenrohr einer großkalibrigen Waffe bezeichnet, in der eine erfindungsgemäße Vorrichtung 2 angeordnet ist. Die Vorrichtung 2 umfaßt im wesentlichen zwei Elektrodeneinrichtungen 3 und 4, die sich an der inneren Oberfläche 5 des Rohres 1 abstützen und die jeweils mindestens eine Hauptelektrode 6, 7 umfassen, zwischen denen der zu verdampfende Draht 8 befestigt wird (Fig.1).

Bei der Elektrodeneinrichtung 3 ist die Hauptelektrode 6 in einem Teilbereich von einem Isolierkörper 9 umgeben, der sich umfangseitig an der inneren Oberfläche 5 des Rohres 1 abstützt. Außerdem ist der zu verdampfende Draht 8 durch die Elektrode 6 hindurchgeführt und auf einem Spulenkörper 10 aufgewickelt, so daß durch Auseinanderziehen der Elektrodeneinrichtungen 3, 4 in dem Waffenrohr 1 Teilbereiche unterschiedlicher Länge oder aber auch das gesamte Waffenrohr 1 beschichtet werden können.

Die Elektrodeneinrichtung 4 besteht in dem dargestellten Ausführungsbeispiel im wesentlichen aus einem Metallkörper 11, der einerseits die Hauptelektroden 7 umfaßt und andererseits auf seinem äußeren Umfang 12 Hilfselektroden 13 trägt, so daß die Hauptelektrode 7 leitend mit dem z.B. aus Stahl bestehenden Waffenrohr 1 verbunden ist.

Die Elektroden 6, 7 sind über elektrische Leitungen 14, 15 und einem Schalter 16 mit einer nur schematisch angedeuteten Kondensatorbatterie 17 verbunden.

Wird der Schalter 16 geschlossen, so entlädt sich die in den Kondensatoren der Batterie 17 gespeicherte Energie, und der zwischen den Elektrodeneinrichtungen 3 und 4 gespannte Draht 8 wird durch den entsprechenden Stromimpuls schlagartig zum Verdampfen gebracht (Drahtexplosion) (Fig.2). Die bei dem Verdampfungsvorgang entstehenden Teilchen erreichen eine hohe Fluchtgeschwindigkeit und treffen dadurch mit hoher kinetischer Energie auf die innere Rohroberfläche 5, die sich beim Aufprall zum großen Teil in Wärme umsetzt. Dadurch wird eine Schicht 18 auf der inneren Oberfläche 5 des Rohres 1 aufgebaut (Fig.3), die sich unter Bildung einer Legierung zwischen dem Rohrwerkstoff und dem Schichtwerkstoff mit dem Rohr verbindet und eine hohe Haftfestigkeit aufweist.

Um das Waffenrohr mit einer hinreichend dicken Schicht zu versehen, sind in der Regel mehrere Drahtexplosionen erforderlich.

Aufgrund ihres hohen Schmelzpunktes eignen sich als Schichtwerkstoffe vorzugsweise Refraktärmetalle, wie Niob, Tantal, Molybdän, Wolfram, Hafnium etc., und deren Legierungen. Diese Metalle sind aus wässerigen Elektrolyten nicht galvanisch abscheidbar.

Die Erfindung ist selbstverständlich nicht auf das vorstehende konkret beschriebene Ausführungsbeispiel beschränkt. So kann beispielsweise das Waffenrohr 1 vor Einleitung der Drahtexplosion evakuiert werden, wobei das Rohr stirnseitig gasdicht mittels entsprechender Flansche verschlossen wird. Auch ist es möglich, die Elektrodeneinrichtungen anders -als in den Fig. dargestellt ist- aufzubauen. So kann beispielsweise auch die zweite Elektrodeneinrichtung durch einen Isolierkörper an der Rohrinnenwand abgestützt und direkt über eine elektrische Leitung mit der Kondensatorbatterie verbunden werden.

### Bezugszeichenliste

- 1: Waffenrohr, Metallrohr, Rohr
- 2: Vorrichtung
- 3,4: Elektrodeneinrichtungen
- 5: innere Oberfläche
- 6, 7: Hauptelektroden
- 8: Draht
- 9: Isolierkörper
- 10: Spulenkörper
- 11: Metallkörper
- 12: äußere Umfang
- 13: Hilfselektroden
- 14,15: elektrische Leitungen
- 16: Schalter
- 17: Kondensatorbatterie
- 18: Schicht, Schichtwerkstoff

## Patentansprüche

1. Verfahren zum Innenbeschichten eines Metallrohres (1) **oder eines Rohrabschnittes des Metallrohres,** insbesondere eines Waffenrohres, mit einem elektrisch leitfähigen Schichtwerkstoff (18), **mit den Merkmalen:**
**a) das Metallrohr (1) wird an seinen beiden Stirnseiten mittels Flanschen gasdicht verschlossen und entweder evakuiert oder mit einem Arbeitsgas geflutet;**
**b) zur Beschichtung der inneren Oberfläche (5) des Metallrohres (1) oder eines Rohrabschnittes werden auf den beiden die zu beschichtende innere Oberfläche (5) begrenzenden Seiten des Metallrohres (1) oder Rohrabschnittes jeweils eine den Querschnitt des Metallrohres ausfüllende und sich an der inneren Oberfläche des Rohres abstützende Elektrodeneinrichtung (3,4) eingebracht, wobei mindestens eine der beiden Elektrodeneinrichtungen sich über einen Isolierkörper an der inneren Oberfläche des Metallrohres (1) abstützt;**
c) der Schichtwerkstoff (18) wird in Form eines Drahtes (8) **zwischen den beiden Elektrodeneinrichtungen (3,4)** in Richtung der Rohrachse angeordnet;
d) anschließend wird durch den Draht (8) ein elektrischer Stromimpuls hindurchgeleitet, dessen Stromstärke derart gewählt wird, daß der Draht schlagartig verdampft, so daß die verdampften Partikel des Schichtwerkstoffes (18) auf die innere Oberfläche (5) des Rohres aufprallen und dort eine entsprechende Schicht (18) bilden.

2. Verfahren nach Anspruch 1, **dadurch gekennzeichnet,** daß zum Auforingen eines karbidbildenden Beschichtungswerkstoffes auf die innere Oberfläche des Rohres als Arbeitsgas Methan verwendet wird.

3. Verfahren nach Anspruch 1, **dadurch gekennzeichnet,** daß als Schichtwerkstoff Refraktärmetalle, wie Niob, Tantal, Molybdän, Wolfram Hafnium etc., oder deren Legierungen verwendet werden.

4. Verfahren nach einem der Ansprüche 1 bis 3, **dadurch gekennzeichnet,** daß die Innenbeschichtung des Rohres abschnittsweise zeitlich nacheinander vorgenommen wird.

5. Vorrichtung zur Durchführung des Verfahrens nach einem der Ansprüche 1 bis 6, umfaßend
**zwei Flansche, mittels welcher das Metallrohr (1) an seinen beiden Stirnseiten gasdicht verschließbar ist;**
zwei in das zu beschichtende Rohr (1) einbringbare und sich an der inneren Oberfläche (5) des Rohres (1) abstützende Elektrodeneinrichtungen (3,4), welche jeweils mindestens eine Hauptelektrode (6,7) umfassen, zwischen denen der zu verdampfende Draht (8) befestigt ist, wobei bei mindestens einer der beiden Elektrodeneinrichtungen (3) die entsprechende Elektrode (6) von einem Isolierkörper (9) umgeben ist, der sich an der inneren Oberfläche (5) des zu beschichtenden Rohres (1) abstützt.

6. Vorrichtung nach Anspruch 5, **dadurch gekennzeichnet,** daß eine der beiden Elektrodeneinrichtungen (3,4) auf ihrer der inneren Oberfläche (5) des Rohres (1) zugewandten Seite mit Hilfselektroden (13) versehen ist, welche die Hauptelektrode (7) mit der inneren Oberfläche (5) des zu beschichtenden Rohres (1) verbinden.

## Claims

1. Process for internally coating a metal tube (1) or a section of a metal tube, particularly that of a gun barrel, with an electrically conductive material (18), the process having the following characteristics:
(a) the metal tube (1) is closed in a gas-tight manner at the two end faces thereof by means of flanges and either evacuated or flushed or filled with an operating gas;
(b) for coating the internal surface (5) of the metal tube (1) or a section of the tube, an electrode device (3,4) which in each case fills the cross section of the metal tube (1) and bears against the internal surface of the tube, is inserted on both sides of the metal tube or tube which delimit the internal surface (5) to be coated, at least one of the two electrode devices bearing, through an insulating body, against the internal surface of the metal tube (1);
(c) the coating material (18) is provided in the form of a wire (8) extending between the two electrode devices (3,4) along the axial direction of the tube;
(d) an electrical current pulse then being passed through the wire (8), the intensity of the current being selected to ensure that the wire suddenly vapourises, whereby the vapourised particles of the coating material (18) impact the internal surface (5) of the tube to form an appropriate coating (18).

2. Process in accordance with Claim 1, characterised by the fact that methane is used an operating gas for applying a carbide-forming coating material to the internal surface of the tube.

3. Process in accordance with Claim 1, characterised by the fact that the coating material used consists of refractory metals such as niobium, tantalum, molybdenum, tungsten, hafnium etc. or alloys thereof.

4. Process in accordance with any one of Claims 1 to 3, characterised by the fact that the process of internally coating the tube is effected in succeeding stages.

5. Apparatus for the performance of the process according to any one of Claims 1 to 6, comprising
two flanges by means of which the metal tube (1) can be closed in a gas-tight manner at the two end faces;
two electrode devices (3,4) which are insertable in the tube (1) to be coated and which bear against the internal surface (5) of the tube (1) and each of which comprises at least one main electrode (6,7) and between which the wire (8) to be evaporated is secured, at least one of the two electrode devices (3) has the corresponding electrode (6) surrounded by an insulating body (9) which bears against the internal surface (5) of the tube (1) to be coated.

6. Apparatus in accordance with Claim 5, characterised by the fact that one of the two electrode devices is provided, on the side thereof facing towards the internal surface (5) of the tube (1), with auxiliary electrodes (13) which connect the main electrode (7) with the internal surface (5) of the tube (1) to be coated.

## Revendications

1. Procédé d'application d'un revêtement intérieur sur un tube métallique (1) ou un tronçon de tube métallique, notamment un tube d'arme, revêtement constitué d'un matériau de revêtement (18) électriquement conducteur, présentant les caractéristiques suivantes :
a) le tube métallique (1) est fermé de manière étanche aux gaz, au moyen de flasques sur ses deux faces frontales et soit on y fait le vide, soit on le remplit d'un gaz de travail ;
b) pour appliquer le revêtement sur la surface intérieure (5) du tube métallique (1) ou d'un tronçon de tube, on applique sur chacun des deux côtés du tube métallique (1) ou du tronçon de tube, qui limitent la surface intérieure (5) à recouvrir, un dispositif à électrodes (3, 4) qui remplit la section du tube métallique et qui prend appui contre la surface intérieure du tube, l'un au moins des deux dispositifs à électrodes prenant appui, par l'intermédiaire d'un corps isolant, contre la surface intérieure du tube métallique (1) ;
c) le matériau de recouvrement (18) est disposé sous la forme d'un fil métallique (8) entre les dispositifs à électrodes (3, 4) dans la direction de l'axe du tube ;
d) ensuite, on envoie à travers le fil (8) une impulsion de courant électrique dont l'intensité est choisie de manière que le fil s'évapore brusquement, ce qui fait que les particules évaporées du matériau de recouvrement (18) rebondissent sur la surface intérieure (5) du tube et y forment une couche (18) correspondante.

2. Procédé selon la revendication 1, caractérisé en ce que pour appliquer un matériau de revêtement formant un carbure sur la surface intérieure du tube on utilise du méthane comme gaz de travail.

3. Procédé selon la revendication 1, caractérisé en ce qu'on utilise comme matériau de recouvrement des métaux réfractaires tels que du niobium, du tantale, du molybdène, du tungstène, du hafnium, etc., ou leurs alliages.

4. Procédé selon l'une des revendications 1 à 3, caractérisé en ce que le revêtement intérieur du- tube est appliqué par tronçons, l'un après l'autre dans le temps.

5. Dispositif pour la mise en oeuvre du procédé selon l'une des revendications 1 à 6, comprenant deux flasques au moyen desquels le tube métallique (1) peut être fermé de manière étanche aux gaz sur ses deux faces frontales ;
deux dispositifs à électrodes (3, 4) à introduire dans le tube (1) à recouvrir et prenant appui contre la surface intérieure (5) du tube (1), qui comprennent chacun au moins une électrode principale (6, 7) entre lesquels est fixé le fil métallique (8) à vaporiser, dans l'un au moins des deux dispositifs à électrodes (3), l'électrode (6) correspondante étant entourée par un corps isolant (9) qui prend appui contre la surface intérieure (5) du tube (1) à recouvrir.

6. Dispositif selon la revendication 5, caractérisé en ce que l'un des deux dispositifs à électrodes (3, 4) est pourvu, sur le côté tourné vers la surface intérieure (5) du tube (1), d'électrodes auxiliaires (13) qui relient l'électrode principale (7) à la surface intérieure (5) du tube (1) à recouvrir.
